# EUROPEAN PATENT APPLICATION

(11) **EP 3 166 304 A1**
(43) Date of publication of application: **10.05.2017**
(21) Application number: 16197177.5
(22) Date of filing: 03.11.2016
(51) Int. Cl.: H04N 5/225, G02B 5/04, H01L 27/146

(54) **CAMERA WITH LIGHT-GUIDE ARRAY FOR CAMERA AUTOMATED VEHICLES**

(30) Priority: 05.11.2015 US 201514933097
(71) Applicant: Delphi Technologies, Inc., Troy, MI 48007 (US)
(72) Inventor: LOW, Yew Kwang, 738082 Singapore (SG); YEO, Kok Wee, 530430 Singapore (SG); YEO, Chee Keng, 575728 Singapore (SG)
(74) Representative: Delphi France SAS

(57) **Abstract**

A camera (10) suitable for use on an automated vehicle includes an imager-device (12), a lens-module (30), and an array (34) of light-guides (36). The imager-device (12) is operable to determine an image (14) and includes a plurality of light-detecting pixels (20). Each pixel is overlaid with a micro-lens (22). The lens-module (30) directs light (26) from a field-of-view (32) of the camera (10) toward the imager-device (12). The array (34) of light-guides (36) is interposed between the lens-module (30) and the imager-device (12), and is arranged so each instance of light-guide (36) is aligned with a corresponding instance of micro-lens (22). Each light-guide (36) is defined by a lens-end (38) and an imager-end (40). The lens-end (38) of each of the light-guides (36) cooperates to define a planar-surface (42) of the array (34), and imager-end (40) of the light-guide (36) is characterized by an angle (44) selected to direct light (26) within the light-guide (36) toward the corresponding instance of the micro-lens (22). The angle (44) is determined based on a chief-ray-angle (24) (CRA (24)) of light (26) from the lens-module (30) impinging on the lens-end (38).

## Description

### TECHNICAL FIELD OF INVENTION

This disclosure generally relates to a camera suitable for use on an automated vehicle, and more particularly relates to an array of light-guides interposed between a lens-module and an imager-device, where an imager end of each light-guide has an angle based on a chief-ray-angle (CRA) of light from the lens-module.

### BACKGROUND OF INVENTION

It is desirable to decrease the cost and size of a camera. One way is to select a lens-assembly or lens-module that provides an increased chief-ray-angle (CRA) as a camera that uses a lens-module designed with a smaller prescribed maximum CRA is generally more expensive and larger in size. However, pixels located near the perimeter of an imager-device may suffer from unacceptable roll-off when the chief ray angle becomes quite steep. This is especially true in applications for wide angular field-of-view (short focal length) applications. It has been suggested to equip the imager-device with micro-lenses in an effort to increase the amount of light making it to the active pixel area. However, like other lenses, micro-lenses have an angular acceptance in which they operate most efficiently. As the angle of incidence increases, the amount of light that makes it to the active area of the pixel is reduced. Many lens designs attempt to keep their image space chief ray angles less than seven degrees in order to reduce these effects. It has also been suggested to use a half telecentric type lens so the CRA at the focal plane is near to 0 degree, but doing so undesirably increases the cost and size of the camera.

### SUMMARY OF THE INVENTION

Described herein is a camera that adds an array of light-guides to allow the use of a lower cost lens-module with better optical performance, lower cost, but larger maximum CRA to be used on imaging devices with a smaller prescribed maximum CRA. This is achieved by refracting larger CRA ray bundles exiting the lens toward individual pixels of an imager-device via an array of light-guides, where each light-guide is aligned with a corresponding pixel.

In accordance with one embodiment, a camera suitable for use on an automated vehicle is provided. The camera includes an imager-device, a lens-module, and an array of light-guides. The imager-device is operable to determine an image. The imager-device includes a plurality of light-detecting pixels, and each pixel is overlaid with a micro-lens. The lens-module is operable to direct light from a field-of-view of the camera toward the imager-device. The array of light-guides is interposed between the lens-module and the imager-device. The array is arranged so each instance of light-guide is aligned with a corresponding instance of micro-lens. Each light-guide is defined by a lens-end and an imager-end. The lens-end of each of the light-guides cooperates to define a planar-surface of the array. The imager-end of the light-guide is characterized by an angle selected to direct light within the light-guide toward the corresponding instance of the micro-lens. The angle is determined based on a chief-ray-angle (CRA) of light from the lens-module impinging on the lens-end.

Further features and advantages will appear more clearly on a reading of the following detailed description of the preferred embodiment, which is given by way of non-limiting example only and with reference to the accompanying drawings.

### BRIEF DESCRIPTION OF DRAWINGS

The present invention will now be described, by way of example with reference to the accompanying drawings, in which:
Fig. 1 is a side view of a camera equipped with an array of light-guides in accordance with one embodiment;
Fig. 2A is an isometric view of an imager-side of the array of light-guides shown in Fig. 1 in accordance with one embodiment;
Fig. 2B is a close-up isometric view of the array of light-guides shown in Fig. 1 in accordance with one embodiment;
Fig. 3 is a close-up side view of the camera shown in Fig. 1 in accordance with one embodiment; and
Fig. 4 is an front view of a lens-side of the array of light-guides shown in Fig. 1 in accordance with one embodiment.

### DETAILED DESCRIPTION

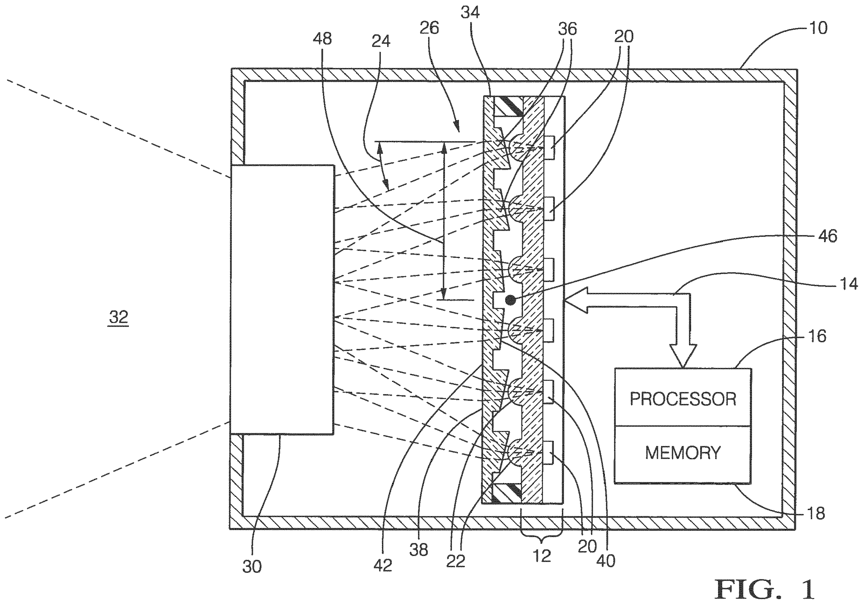

Fig. 1 illustrates a non-limiting example of a camera 10 suitable for use on an automated vehicle (not shown). Those in the art will recognize that the teachings for making the camera 10 described herein will be useful on a fully automated vehicle, i.e. an autonomous vehicle, as well as on a vehicle that is partially automated, i.e. a vehicle that is generally driven by an operator (not shown) but provides assistance to the operator when necessary to, for example, detect/avoid an impending collision. The camera 10 described herein provides for a low cost, wide field-of-view camera design that is well-suited for automotive applications. However, it is recognized that teachings presented herein are also applicable to non-automotive applications such as a stand-alone, purpose-built camera, or a camera integrated into another device such as a smart-phone or tablet.

The camera 10 includes an imager-device 12 operable to determine or output an image 14 to, for example, a processor 16. The processor 16 may include a general-purpose type processor such as a microprocessor, a purpose built image-processor, or other control circuitry such as analog and/or digital control circuitry including an application specific integrated circuit (ASIC) for processing the image 14 as should be evident to those in the art. The processor 16 may communicate with memory 18, including non-volatile memory, such as electrically erasable programmable read-only memory (EEPROM) for storing one or more instances of the image 14 for the purpose of relatively long-term storage, or further image processing.

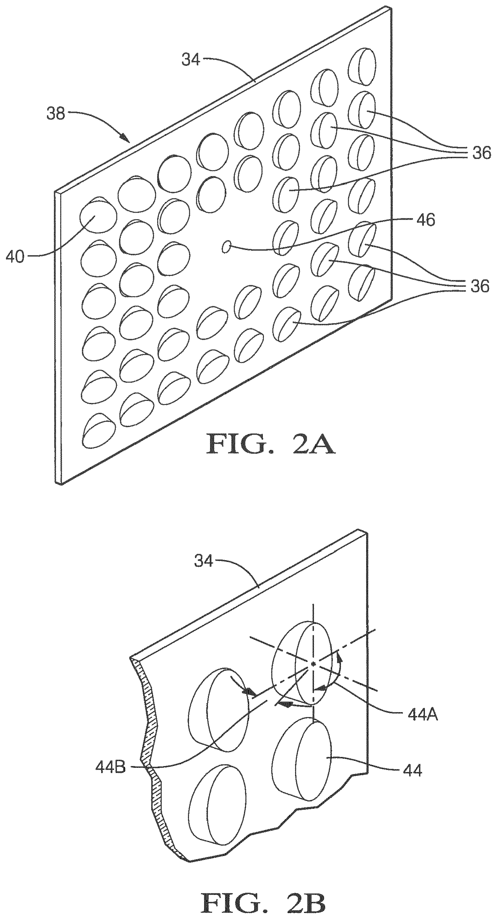

The imager-device 12 generally includes a plurality of light-detecting pixels 20, each pixel overlaid with a micro-lens 22, the purpose and construction of which is well-known. While the illustration shows six instances of the pixels 20, this is only to simplify the illustration and due to the perspective, see Fig. 2A. It is recognized that that commercially-available examples of the imager-device have thousands of pixels, for example a matrix of 1280x960 pixels. However, it is also known that there is a limit to the chief-ray-angle, hereafter the CRA 24, which the imager-device 12 can tolerate and still effectively capture the image 14. That is, if the CRA 24 is greater than, for example nine-degrees (9°), the image 14 may be degraded around the perimeter because the amount of light 26 impinging on an instance of the micro-lens 22 and directed to a corresponding instance of the pixels 20 is reduced.

The imager-device 12 also generally includes a lens-module 30 operable to direct light from a field-of-view 32 of the camera 10 toward the imager-device 12. As will be recognized by those in the art, if it is desired that the lens-module 30 have a relatively wide field-of-view, but the maximum value of the CRA 24 is limited by the imager-device 12, the cost of the lens-module 30 undesirable increases. However, the cost of the lens-module 30 could be reduced while still providing the field-of-view 32 that is desired if a larger value of the CRA 24 could be utilized. In order to satisfy these conflicting requirements or desires, but still provide for an economical design, the camera 10 advantageously includes an array 34 of light-guides 36 interposed between the lens-module 30 and the imager-device 12. The array 34 is arranged so each instance of light-guide 36 is aligned with a corresponding instance of micro-lens 22.

Figs. 2A and 2B show further non-limiting details of the array 34 and the light-guides 36 that form the array 34. Each light-guide is defined by a lens-end 38 of the light-guide 36 oriented toward the lens-module 30, and an imager-end 40 of the light-guide 36 oriented toward the imager-device 12. In this non-limiting example, the lens-end 38 of each of the light-guides 36 cooperates to define a planar-surface 42 of the array 34. That is, the lens-ends 38 of all of the light-guides 36 that form the array 34 are co-planar. An alternative configuration of the array 34 is contemplated where the lens-ends 38 of each of the light-guides 36 is angled in a manner similar to that shown for the imager-end, the reason for doing so is explained below. The array 34 may be fabricated by molding or other known means used to fabricate the micro-lens 22.

The imager-end 40 of each of the light-guides 36 is characterized by an angle 44 that is selected to direct light within the light-guide 36 toward the corresponding instance of the micro-lens 22. The angle is determined based on the CRA 24 of the light 26 from the lens-module 30 that is impinging on the lens-end 38, i.e. the planar surface 42. As such, the angle 44 may be a compound angle that can be expressed in terms of an azimuth-angle 44A and/or a tilt-angle 44B. Computer modeling of the camera 10 that includes a suitable example of the array 34 overlaying the imager-device 12 as described herein indicates that as a result of adding the array 34, the lens-module 30 can be configured so the maximum value of the CRA 24 impinging on the array 34 is thirty-one degrees (31 °) rather than the previously suggested limit for a camera with a similar example of the imager-device 12 but without the array 34. This performance is realized for a light-guide formed by material with an index of refraction of 1.8 and having the angle 44 set at twenty-seven degrees (27°) where a zero degree tilt of the imager-end 40 is parallel to the planar surface 42.

By way of further explanation, the imager-device may be characterized as defining a center-point 46. The angle 44 may then be characterized as being determined based on a profile (e.g. a graphical curve or a non-linear equation) of the lens-module 30 that characterizes the CRA 24 versus a distance 48 of the corresponding instance of the micro-lens 22 from the center-point 46. It is noted that instances of the light-guides 36 near the center-point may not require the imager-end to be angled. That is, as shown in Fig. 2A, the imager-end 40 of the light-guides 36 proximate to the center-point may be coplanar similar to the lens-end 38 of those instances of the light-guides 36.

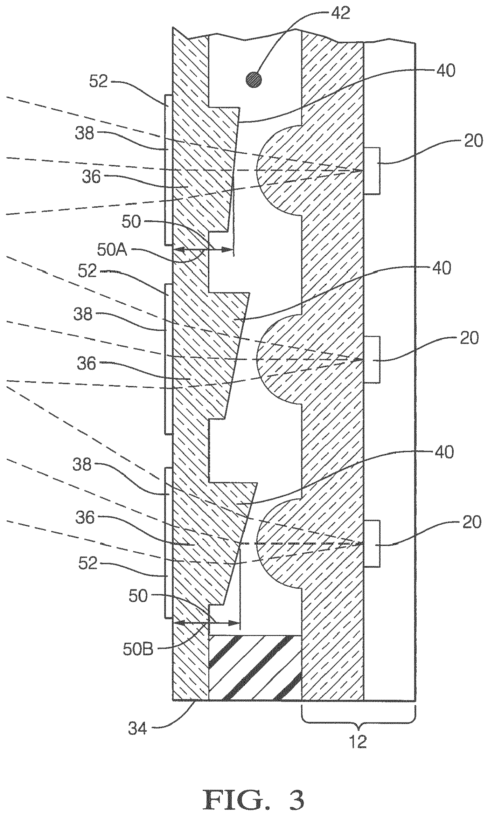

Fig. 3 shows further non-limiting details of the camera 10. As will be recognized by those in the art, typical examples of the lens-module 30 (Fig. 1) with a relatively wide-angle for the field-of-view 32 will exhibit a substantial focal-field curvature so that light detected by the pixels 20 near the center-point 46 may be well-focused, while light detected by the pixels 20 that are substantially distant from the center-point 46, i.e. at the periphery of the imager-device 12 are not well-focused. This problem is further exacerbated if the imager-device 12 is a relatively large format sensor. In order to correct for this focal-field curvature, the array 34 may be advantageously configured so each of the light-guides 36 is characterized by a guide-length 50 indicative of a distance between the lens-end 38 and the imager-end 40. As the guide-length 50 increases, the back focal length (BFL) of respective instance of the light-guide 36 increases, such that the focal point is shifted further to the image plane at the outer field where field curvature of lens causes defocus. By configuring the array 34 so the guide-length 50 of the light-guides 36 is smaller or shorter near the center-point 46 when compared to the guide-length 50 of the light-guides 36 that are distant or well displaced from the center-point 46, array 34 will help to flatten the field curvature further to provide a more uniformly focused image across the imager-device. In this example the guide-length 50A is less than the guide-length 50B. As such, the guide-length 50 of each of the light-guides 36 increases as the displacement of the light-guide 36 from the center-point 46 increases.

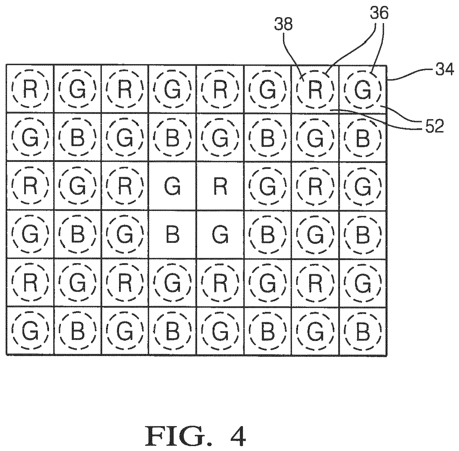

Fig. 4 illustrates further non-limiting details of the array 34 where each of the light-guides 36 includes or is equipped with a filter-element 52. In this example, the filter-element is located at or applied to the lens-end 38 if each of the light-guides 36, however this is not a requirement. Alternatively, the filter-element could be applied to the imager-end 40, or could be integrated in to the material used to form the each of the light-guides, i.e. the material used to form the light-guides 36 could be colored or tinted. If it is desired that the filtering effect of each of the light-guides 36 be uniquely determined as suggested by the red (R), green (G), and blue (B) instances of the filter-elements 52 shown in Fig. 4, then applying the filter-element 52 upon the lens-end 38 may be preferable for manufacturing reasons so as to simplify the assembly process of the camera 10 by reducing the total part count.

Accordingly, a camera 10 is provided that includes an array 34 of light-guides 36 which. The array is effective to increase the maximum allowable CRA of the imaging device so as to allow the use of larger CRA lens module, and thereby provides for a camera with better performance, smaller in size and lower in cost. Furthermore, the guide-length 50 of the light-guides 36 can be varied to correct for focal-field curvature and thereby improve the clarity of images for cameras with wide fields-of-view.

While this invention has been described in terms of the preferred embodiments thereof, it is not intended to be so limited, but rather only to the extent set forth in the claims that follow.

## Claims

1. A camera (10) suitable for use on an automated vehicle, said camera (10) comprising:
an imager-device (12) operable to determine an image (14), said imager-device (12) includes a plurality of light-detecting pixels (20), each pixel overlaid with a micro-lens (22);
a lens-module (30) operable to direct light (26) from a field-of-view (32) of the camera (10) toward the imager-device (12); and
an array (34) of light-guides (36) interposed between the lens-module (30) and the imager-device (12), said array (34) arranged so each instance of light-guide (36) is aligned with a corresponding instance of micro-lens (22), each light-guide (36) defined by a lens-end (38) and an imager-end (40), the lens-end (38) of each of the light-guides (36) cooperating to define a planar-surface (42) of the array (34), the imager-end (40) of the light-guide (36) **characterized by** an angle (44) selected to direct light (26) within the light-guide (36) toward the corresponding instance of the micro-lens (22), wherein the angle (44) is determined based on a chief-ray-angle (24) (CRA (24)) of light (26) from the lens-module (30) impinging on the lens-end (38).

2. The camera (10) in accordance with claim 1, wherein the imager-device (12) defines a center-point (46), and the angle (44) is further determined based on a profile of the lens-module (30) that characterizes the CRA (24) versus a distance (48) of the corresponding instance of the micro-lens (22) from the center-point (46).

3. The camera (10) in accordance with claim 1 or 2, wherein each of the light-guides (36) is **characterized by** a guide-length (50) indicative of a distance (48) between the lens-end (38) and the imager-end (40).

4. The camera (10) in accordance with claim 3, wherein the imager-device (12) defines a center-point (46), and the guide-length (50) of each of the light-guides (36) increases as the displacement of the light-guide (36) from the center-point (46) increases.

5. The camera (10) in accordance with any one of claims 1 to 4, wherein each of the light-guides (36) includes a filter-element (52).

6. The camera (10) in accordance with claim 5, wherein the filter-element (52) is applied to the lens-end (38).
